## Europäisches Patentamt
## European Patent Office
## Office européen des brevets

(19)

(11) Veröffentlichungsnummer: **0 030 356**
**B1**

(12) **EUROPÄISCHE PATENTSCHRIFT**

(45) Veröffentlichungstag der Patentschrift:
01.08.84

(51) Int. Cl.³: **H 03 K 19/091**, H 03 K 19/013

(21) Anmeldenummer: **80107533.4**

(22) Anmeldetag: **02.12.80**

(54) Monolithisch integrierte Halbleiterschaltung mit einander gleichen I2L-Zellen.

(30) Priorität: 06.12.79 DE 2949201

(43) Veröffentlichungstag der Anmeldung:
17.06.81 Patentblatt 81/24

(45) Bekanntmachung des Hinweises auf die Patenterteilung:
01.08.84 Patentblatt 84/31

(84) Benannte Vertragsstaaten:
FR GB IT

(56) Entgegenhaltungen:
DE - A - 2 614 580
DE - A - 2 723 973
US - A - 4 007 385
US - A - 4 013 901

VALVO BERICHTE, Band XVIII, Nr. 1/2, April 1974
Hamburg O. JAKITS "Integrierte Injektionslogik, ein neuartiges Prinzip für Digitalschaltungen" Seiten 215 bis 226
IEEE JOURNAL OF SOLID-STATE CIRCUITS, Band SC-12, Nr. 2, April 1977 K. KANEKO et al. "Stacked I2L Circuit" Seiten 210 bis 212
IBM TECHNICAL DISCLOSURE BULLETIN, Band 19, Nr. 9, Februar 1977 J.B. GILLETT "Improvement to Integrated Injection Logic" Seiten 3451 bis 3452

(73) Patentinhaber: **SIEMENS AKTIENGESELLSCHAFT,
Berlin und München Wittelsbacherplatz 2,
D-8000 München 2 (DE)**

(72) Erfinder: **Umkehrer, Walter, Dipl.-Ing.,
Bernheimerstrasse 4, D-8000 München 81 (DE)**

**Beschreibung**

Die Erfindung betrifft eine monolithisch integrierte Halbleiterschaltung mit einander gleichen $I^2$L-Zellen, bei der die Versorgungsspannung ein Mehrfaches der für den Betrieb der einzelnen $I^2$L-Zellen benötigten Betriebsspannung beträgt und bei der demgemäss eine entsprechende Anzahl von $I^2$L-Zellen bezüglich der die Versorgungsspannung für die Halbleiterschaltung liefernden beiden Versorgungsanschlüsse der Halbleiterschaltung kettenartig hintereinandergeschaltet sind (stacking), indem der Eingang des Injektors der das erste Kettenglied bildenden $I^2$L-Zelle unmittelbar mit dem das Versorgungspotential liefernden ersten Versorgungsanschluss und der Eingang des Injektors der die übrigen Kettenglieder bildenden $I^2$L-Zelle jeweils mit dem Fusspunkt der in der Kette in Richtung auf den ersten Versorgungsanschluss jeweils unmittelbar benachbarten $I^2$L-Zelle verbunden und der Fusspunkt der einzelnen $I^2$L-Zelle durch den Emitter ihres Transistors gegeben ist, während der Fusspunkt der letzten $I^2$L-Zelle der Kette unmittelbar an dem das Bezugspotential führenden zweiten Versorgungsanschluss liegt, und bei der schliesslich der Kollektor des Transistors wenigstens einer $I^2$L-Zelle der Kette zur Steuerung des Basisanschlusses des Transistors einer weiteren $I^2$L-Zelle dient, deren Fusspunkt mit einem Potential beaufschlagt ist, das näher dem am zweiten Versorgungsanschluss liegenden Bezugspotential als das Potential am Fusspunkt der steuernden $I^2$L-Zelle liegt.

Einzelheiten über $I^2$L-Zellen findet man z. B. in «Valvo Berichte, Band XVIII, Heft 1/2 (1974), Seite 215–226». Bekanntlich besteht die einzelne $I^2$L-Zelle aus der Kombination eines vertikalen npn-Transistors, dessen Basis vom Emitter und dessen Kollektor von der Basis umgeben ist, wobei der Kollektor den Signalausgang und der Basisanschluss den Signaleingang bildet, mit einem Lateral-pnp-Transistor. Dieser bildet den Injektor, wobei die Basis des Lateraltransistors mit dem Emitter des Vertikaltransistors und der Kollektor des Lateraltransistors mit der Basis des Vertikaltransistors identisch sind. Der Emitter des Vertikaltransistors und damit die Basis des Injektors bilden den Fusspunkt der $I^2$L-Zelle und ist demgemäss mit dem für den Betrieb der $I^2$L-Zelle erforderlichen Bezugspotential beaufschlagt. Das Versorgungspotential für die $I^2$L-Zelle wird an den durch den Emitter des Lateraltransistors gegebenen Injektoreingang gelegt, während das in der $I^2$L-Zelle zu verarbeitende Signal sowohl an einem Anschluss der Basis des Vertikaltransistors als auch an den Fusspunkt der $I^2$L-Zelle zu legen ist.

Da die Werte der binären Potentialzustände einer $I^2$L-Zelle $U_H = 0{,}7$ V und $U_L$ etwa $0{,}1$ V betragen und somit ein Spannungshub von etwa $0{,}8$ V gebraucht wird, ergibt sich bei einer monolithischen Kombination von $I^2$L-Zellen mit anderen digitalen Schaltungsteilen das Problem der Anpassung der $I^2$L-Zellen an die für die Gesamtschaltung benötigte Versorgungsspannung, die z. B. bei TTL-Schaltungen etwa 5 V beträgt, während die $I^2$L-Zelle für den Injektor eine Spannung $U_I$ von etwa $0{,}8$ V benötigt. Aus diesem Grund wird in der Praxis der $I^2$L-Schaltungen entsprechend der in der eingangs zu dieser Beschreibung gegebenen Definition so vorgegangen, dass mehrere $I^2$L-Zellen kettenartig hintereinandergeschaltet werden und auf diese Weise gewissermassen ein Netzwerk von $I^2$L-Zellen aufgebaut, das zwischen den beiden Versorgungsanschlüssen des IC's liegt. Dies bedeutet, dass durch die einzelnen Glieder der zwischen den beiden Versorgungsanschlüssen der integrierten Halbleiterschaltung liegenden Kette von $I^2$L-Zellen die zur Verfügung gestellte Betriebsspannung in einander gleiche Teilspannungen unterteilt, die jeweils als Betriebsspannung der das betreffende Kettenglied bildenden $I^2$L-Zelle zugeteilt ist. Die einzelnen Teilbetriebsspannungen sind jedoch gestaffelten Werten für die an dem Fusspunkt der einzelnen $I^2$L-Zellen der Kette sich ausbildenden Bezugspotentiale zugeordnet. Da die einzelnen $I^2$L-Zellen der Kette in der Regel mit weiteren $I^2$L-Zellen zusammenarbeiten, die hinsichtlich ihrer der Einstellung des Arbeitspunkts dienenden Betriebsspannungen ebenfalls als Glieder einer Kette aus $I^2$L-Zellen zwischen den beiden Versorgungsanschlüssen der integrierten Schaltung liegen, kann es vorkommen, dass durch eine $I^2$L-Zelle weitere $I^2$L-Zellen gesteuert werden, die nicht ausschliesslich durch dieselben Werte des an ihrem Injektor liegenden Potentials und des an ihrem Fusspunkt liegenden Potentials wie die sie steuernde $I^2$L-Zelle beaufschlagt sind. So kann eine zu steuernde Zelle durch Betriebspotentiale beaufschlagt sein, die im Vergleich zu den Betriebspotentialen der steuernden Zelle entweder in Richtung auf das Versorgungspotential am ersten Versorgungsanschluss oder in Richtung auf das Bezugspotential am zweiten Versorgungsanschluss der integrierten Schaltung verschoben sind. Im erstgenannten Fall hat man die sogenannte «Aufwärtssteuerung», im zweiten Fall die sogenannte «Abwärtssteuerung».

Während die Aufwärtssteuerung keine besonderen Probleme bringt, ist – wie bereits in der DE-OS 2 723 973 dargelegt wurde – der Abwärtsbetrieb, d. h. also die Abwärtssteuerung, mit einer Verlangsamung des Schaltbetriebs verbunden, weil der Transistor der gesteuerten Zelle beim Abklingen eines von der steuernden $I^2$L-Zelle gelieferten Signals dann besonders lange braucht, um wieder betriebsbereit zu sein.

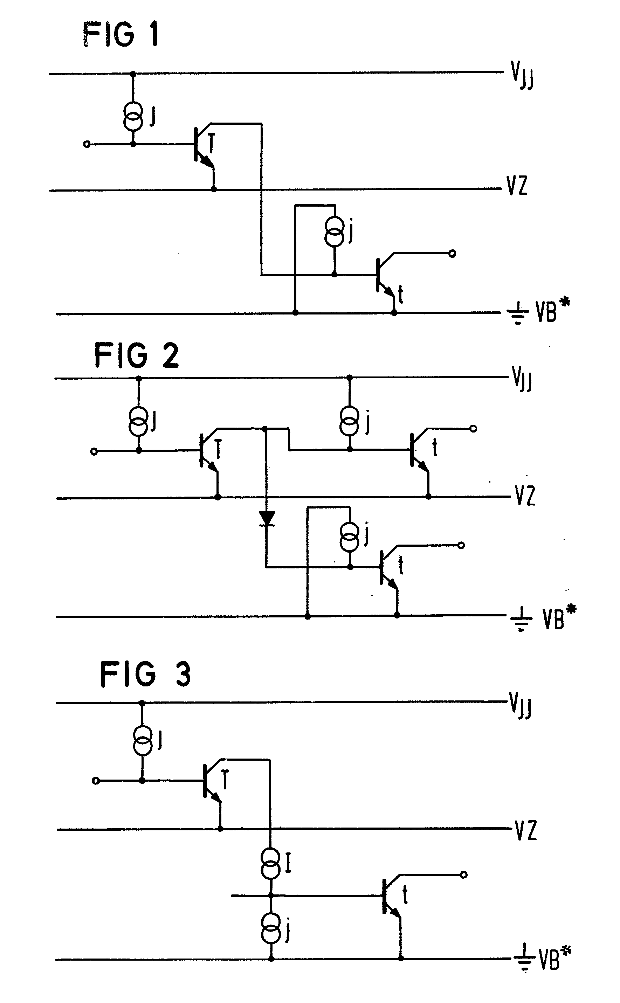

Eine der eingangs gegebenen Definition entsprechende integrierte Schaltung ist ausserdem in der Literaturstelle «IEEE Journal of Solid-State Circuits, April 1977, S. 210 bis 212» beschrieben. Dort ist (vgl. Fig. 2 von S. 211) in Übereinstimmung mit den Offenbarungen der DE-OS 2 737 973 zwischen dem Kollektor des steuernden Transistors und der Basis des Transistors der gesteuerten $I^2$L-Zelle ein weiterer dem Vertikaltransistor der gesteuerten $I^2$L-Zelle entsprechender und gleicher Transistor vorgesehen, dessen Kollektor einerseits mit der Basis des Vertikaltransistors der gesteuerten I²L-Zelle und anderseits mit Ausgang des Injektors der gesteuerten I²L-Zelle verbunden ist. Dabei ist zu bemerken, dass der Injektor der gesteuerten I²L-Zelle so geschaltet ist, dass die gesteuerte I²L-Zelle ein Glied der zwischen den beiden Versorgungsanschlüssen der integrierten Schaltung bildet.

Die gesteuerte I²L-Zelle muss also bei dieser Ausgestaltung durch einen zusätzlichen Transistor erweitert werden, was einen erhöhten Platzbedarf sowie einen erhöhten schaltungstechnischen Aufwand bedeutet. Es ist Aufgabe der Erfindung, hier eine Vereinfachung zu erzielen.

Um die genannte Beeinträchtigung der Schaltgeschwindigkeit unter im Vergleich zum Stande der Technik geringeren Aufwand zu beseitigen, wird gemäss der Erfindung vorgeschlagen, dass der Injektor der gesteuerten I²-L-Zelle zwischen der Basis des Transistors und dem Fusspunkt dieser I²L-Zelle liegt.

Die Erfindung wird nun anhand von Fig. 1 bis 3 näher beschrieben. In diesen ist der Transistor T der Transistor der steuernden I²L-Zelle und J ihr Injektor. Das am Eingang des Injektors J liegende Versorgungspotential ist mit $V_{JJ}$ bezeichnet und wird, falls die I²L-Zelle dem ersten Versorgungsniveau angehört, d. h. ein erstes Kettenglied gemäss der Definition der Erfindung darstellt, unmittelbar vom ersten Versorgungsanschluss geliefert. In allen anderen Fällen entspricht das Versorgungspotential $V_{JJ}$ für den Injektor der steuernden I²L-Zelle dem Potential VZ am Fusspunkt der in Richtung auf den ersten Versorgungsanschluss benachbarten I²L-Zelle der zwischen den beiden Versorgungsanschlüssen der integrierten Halbleiterschaltung liegenden und die steuernde I²L-Zelle enthaltenden Kette von entsprechend der Definition der Erfindung hintereinandergeschalteten I²L-Zellen. Dabei wird darauf aufmerksam gemacht, dass im Interesse der Übersichtlichkeit in den Zeichnungen von einer Darstellung der Kette von I²L-Zellen abgesehen wurde, da es sich hier um eine allgemein bekannte, in der Literatur auch als «stacking» bezeichnete Schaltungsstruktur handelt.

Die Transistoren der jeweils gesteuerten I²L-Zelle sind mit t und ihr Injektor mit j bezeichnet. Das Emitterpotential für den Transistor T der steuernden I²L-Zelle ist VZ und entspricht den Potentialen in den einzelnen Knoten des I²L-Netzwerkes, da es durch Spannungsteilung der von den beiden Versorgungsanschlüssen der Schaltung gelieferten Gesamtbetriebsspannung abgeleitet ist.

Bei der in Fig. 1 dargestellten Lösung ist die Basis des Transistors t der gesteuerten Zelle mit dem Kollektor des Transistors T der steuernden I²L-Zelle unmittelbar verbunden. Sind jedoch die Versorgungspotentiale von steuernder und gesteuerter I²L-Zelle nicht unmittelbar benachbart wie in Fig. 1, sondern sind ein oder mehrere Versorgungspotentiale zu überspringen, so müssen ein oder mehrere Dioden derart in die Verbindung vom Kollektor des steuernden Transistors T zur Basis des gesteuerten Transistors t eingeschaltet werden, dass die Anode der Diode oder der Dioden jeweils zum Kollektor des steuernden Transistors T und die Kathode der Diode beziehungsweise Dioden zur Basis des gesteuerten Transistors t weist. Der Eingang des Injektors j der gesteuerten I²L-Zelle und der Emitter ihres Transistors t liegen an einem gemeinsamen Potential VB*, das durch das auf Grund der beschriebenen Spannungsteilung erhaltene Potential an den Emitter der I²L-Zellen eines der Versorgungsniveaus des I²L-Netzwerkes gehörenden I²L-Zellen gegeben ist, das näher an dem Bezugspotential VB der Gesamtschaltung liegt als das Versorgungsniveau $V_{JJ}$/VZ, dem die steuernde I²L-Zelle angehört. Gegebenenfalls kann, wie leicht verständlich, das Potential VB* mit dem Potential VB identisch sein. Entsprechend der Erfindung ist nun der Emitter des Transistors t der gesteuerten I²L-Zelle zusammen mit dem Eingang des Injektors j dieser Zelle an das Emitter-Versorgungspotential VB* eines näher am Bezugspotential VB als das Versorgungsniveau der steuernden I²L-Zelle liegenden Versorgungsniveaus gelegt.

Bei dem in Fig. 2 dargestellten Fall wird einerseits durch den Transistor T der zu steuernden I²L-Zelle eine demselben Versorgungsniveau angehörende Zelle und im Abwärtsbetrieb eine zu einem Versorgungsniveau gehörende weitere I²L-Zelle gesteuert. Die Steuerung erfolgt ebenso wie in Fig. 1 durch Einwirkung des Kollektors des Transistors der steuernden I²L-Zelle auf die Basis des Transistors t der gesteuerten I²L-Zelle.

Bei dem in Fig. 2 dargelegten Fall sind nun durch den Kollektor des Transistors T einer I²L-Zelle zugleich der Eingang einer demselben Versorgungsniveau angehörenden I²L-Zelle und einer einem niedrigeren, d. h. näher am gemeinsamen Bezugspotential VB liegenden Versorgungsniveau angehörenden I²L-Zelle gesteuert. Aus diesem Grunde ist zwischen dem Transistor T der steuernden I²L-Zelle und dem Transistor t der gesteuerten I²L-Zelle aus dem niedrigeren Versorgungsniveau eine Diode vorgesehen, die im Falle der Verbindung zum Transistor t der demselben Versorgungsniveau wie die steuernde I²L-Zelle angehörenden I²L-Zelle nicht erforderlich ist.

Bei der in Fig. 3 dargestellten Anordnung liegt zwischen dem Eingang der dem niedrigeren Versorgungsniveau angehörenden gesteuerten I²L-Zelle und der dem höheren Versorgungsniveau angehörenden steuernden I²L-Zelle ein Injektor I. Dieser entspricht im Aufbau den übrigen Injektoren der I²L-Zellen. Er ist demgemäss durch eine in der Nachbarschaft der Basiszone des Transistors t der dem niedrigeren Versorgungsniveau angehörenden I²L-Zelle angeordnete zweite Injektorzone gegeben, die mit dem Kollektor des Transistors T der steuernden I²L-Zelle leitend verbunden ist, während die den Injektor j bildende erste Injektionszone am Emitter des Transistors t dieser Zelle und mit dieser am zweiten Versorgungspotential VB* dieser Zelle liegt.

Das Ziel der Erfindung besteht darin, dass man versucht, die Ladungsträger in der Basis der Transistoren in den gesteuerten I²L-Zellen möglichst schnell auszuräumen, auch wenn die gesteuerte I²L-Zelle einem niedrigeren Versorgungsniveau angehört als die steuernde I²L-Zelle, und zwar auch für den Fall des Abwärtsbetriebs, d. h. bei einer Steuerung einer einem niedrigeren Versorgungsniveau angehörenden I²L-Zelle durch eine I²L-Zelle aus einem höheren Versorgungsniveau. Erreicht wird durch die Erfindung, dass auch in diesem Fall die Schaltgeschwindigkeit nicht langsamer wird als im Falle, dass die steuernde I²L-Zelle und die gesteuerte I²L-Zelle demselben Versorgungsniveau angehören.

Sind beim Umsteigen gleichzeitige logische Verknüpfungen zwischen I²L-Zellen desselben Versorgungsniveaus und I²L-Zellen niedrigeren Versorgungsniveaus vorgesehen, so wird die in Fig. 2 ersichtliche Diode zwischen dem Ausgang der dem höheren Versorgungsniveau steuernden I²L-Zelle und dem Eingang der einem niedrigeren Versorgungniveau angehörenden gesteuerten I²L-Zelle vorgesehen, während eine solche Diode für die Steuerung der demselben Versorgungsniveau wie die steuernde I²L-Zelle angehörenden I²L-Zelle nicht erforderlich ist. Dabei ist die Anode der Diode D mit dem Kollektor des Transistors T der steuernden I²L-Zelle und die Kathode dieser Diode D mit der Basis des Transistors t der dem niedrigeren Versorgungsniveau angehörenden I²L-Zelle verbunden.

Die Schaltung wird zumeist derart ausgeführt, dass der Vertikaltransistor T bzw. t vom npn-Typ, der Lateraltransistor, also der Injektor J, j, I, vom pnp-Typ ist. Umgekehrt könnte auch der Vertikaltransistor vom pnp-Typ und der Lateraltransistor vom npn-Typ sein. Das bedeutet dann eine Umkehr der Betriebsspannungen.

**Patentansprüche**

1. Monolithisch integrierte Halbleiterschaltung mit einander gleichen I²L-Zellen, bei der die Versorgungsspannung ein Mehrfaches der für den Betrieb der einzelnen I²L-Zellen benötigten Betriebsspannung beträgt und bei der demgemäss eine entsprechende Anzahl von I²L-Zellen bezüglich der die Versorgungsspannung für die Halbleiterschaltung liefernden beiden Versorgungsanschlüsse der Halbleiterschaltung kettenartig hintereinandergeschaltet sind (stacking), indem der Eingang des Injektors der das erste Kettenglied bildenden I²L-Zelle unmittelbar mit dem das Versorgungspotential liefernden ersten Versorgungsanschluss und der Eingang des Injektors der die übrigen Kettenglieder bildenden I²L-Zellen jeweils mit dem Fusspunkt der in der Kette in Richtung auf den ersten Versorgungsanschluss jeweils unmittelbar benachbarten I²L-Zelle verbunden und der Fusspunkt der einzelnen I²L-Zelle durch den Emitter ihres Transistors gegeben ist, während der Fusspunkt der letzten I²L-Zelle der Kette unmittelbar an dem das Bezugspotential (VB*) führenden zweiten Versorgungsanschluss liegt, und bei der schliesslich der Kollektor des Transistors (T) wenigstens einer I²L-Zelle der Kette zur Steuerung des Basisanschlusses des Transistors (t) einer weiteren I²L-Zelle dient, deren Fusspunkt mit einem Potential (VZ) beaufschlagt ist, das näher dem am zweiten Versorgungsanschluss liegenden Bezugspotential (VB*) als das Potential (VZ) am Fusspunkt der steuernden I²L-Zelle liegt, dadurch gekennzeichnet, dass der Injektor (j) der gesteuerten I²L-Zelle zwischen der Basis des Transistors (t) und dem Fusspunkt dieser I²L-Zelle liegt.

2. Halbleiterschaltung nach Anspruch 1, dadurch gekennzeichnet, dass der Kollektor des Transistors (T) der steuernden I²L-Zelle unmittelbar mit der Basis des Transistors (t) der gesteuerten I²L-Zelle verbunden ist.

3. Halbleiterschaltung nach Anspruch 1, dadurch gekennzeichnet, dass die Steuerung der Basis des Transistors (t) der gesteuerten I²L-Zelle durch den Kollektor des Transistors (T) der steuernden I²L-Zelle unter Vermittlung wenigstens einer Diode erfolgt.

4. Halbleiterschaltung nach Anspruch 3, dadurch gekennzeichnet, dass der Kollektor des Transistors (T) der steuernden I²L-Zelle unmittelbar mit der Basis des Transistors (t) einer weiteren gesteuerten I²L-Zelle verbunden ist, bei der der Eingang des Injektors (j) am Eingang des Injektors (J) der steuernden I²L-Zelle und der Fusspunkt am Fusspunkt der steuernden I²L-Zelle liegt.

5. Halbleiterschaltung nach Anspruch 1, dadurch gekennzeichnet, dass der gesteuerten I²L-Zelle ein zweiter Injektor (I) zugeordnet ist, dessen Eingang am Kollektor des Transistors (T) der steuernden I²L-Zelle und dessen Ausgang an der Basis des Transistors (t) der gesteuerten I²L-Zelle liegt.

**Claims**

1. A monolithic integrated semiconductor circuit having identical I²L-cells, wherein the supply voltage amounts to a multiple of the operating voltage required for the operation of the individual I²L-cells, and wherein in accordance therewith, in respect of two semi-conductor circuit supply terminals for providing an operating potential to the semiconductor circuit, a corresponding number of I²L-cells are consecutively stacked in the form of a chain, the input of the injector of the I²L-cell forming the first chain element being connected to the first supply potential terminal and the input of the injector of the I²L-cells forming the remaining chain elements being connected to the foot point of that I²L-cell directly adjacent in the chain in the direction to the first supply terminal, the foot point of individual I²L-cell being given by the emitter of the associated transistor, but the foot point of the last I²L-cell of the chain being directly connected to the second supply terminal leading to the reference potential (VB*), and wherein finally the collector of the transistor (T) of at least one I²L-cell of the chain serves to control the base terminal of the transistor (t) of a further I²L-cell, whose foot point is supplied with a potential (VZ) which is clear to the reference potential (VB*) applied to the second supply terminal than the potential (VZ) at the foot point of the controlling I²L-cell, characterised in that the injector (j) of the controlled I²L-cell is arranged between the base of the transistor (t) and the foot point of the I²L-cell.

2. A semiconductor circuit as claimed in claim 1, characterised in that the collector of the transistor (T) of the controlling I²L-cell is directly connected to the base of the transistor (t) of the controlled I²L-cell.

3. A semiconductor circuit as claimed in claim 1, characterised in that the control of the base of the transistor (t) of the controlled I²L-cell is effected by the collector of the transistor (T) of the controlled I²L-cell with the cooperation of at least one diode.

4. A semiconductor circuit as claimed in claim 3, characterised in that the collector of the transistor (T) of the controlling I²L-cell is directly connected to the base of the transistor (t) of a further controlled I²L-cell, wherein the input of the injector (j) is arranged at the input of the injector (J) of the controlling I²L-cell and the foot point is arranged at the foot point of the controlling I²L-cell.

5. A semiconductor circuit as claimed in claim 1, characterised in that the controlled I²L-cell is assigned a second injector (I) whose input is arranged at the collector of the transistor (T) of the controlling I²L-cell and whose output is connected to the basis of the transistor (t) of the controlled I²L-cell.

**Revendications**

1. Circuit intégré monolithique à semiconducteurs comportant des cellules I²L identiques, dans lequel la tension d'alimentation est égale à un multiple de la tension de service nécessaire pour le fonctionnement des différentes cellules I²L et dans lequel par conséquent un nombre correspondant de cellules I²L sont branchées en série selon un montage itératif (stacking) par rapport aux deux bornes d'alimentation du circuit à semiconducteurs, délivrant la tension d'alimentation pour ce circuit, en faisant en sorte que l'entrée de l'injecteur de la cellule I²L formant la première maille est reliée directement à la première borne d'alimentation délivrant un potentiel d'alimentation et que l'entrée de l'injecteur des cellules I²L constituant les autres mailles est reliée respectivement au point de base de la cellule I²L directement voisine dans le réseau itératif en direction de la première borne d'alimentation, et que le point de base d'une cellule I²L individuelle est formé par l'émetteur de son transistor, tandis que le point de base de la dernière·cellule I²L du réseau itératif est raccordé directement à la seconde borne d'alimentation placé au potentiel de référence (VB*), et dans lequel enfin le collecteur du transistor (T) d'au moins une cellule I²L du réseau itératif est utilisée pour la commande du raccord de base du transistor (t) d'une autre cellule I²L dont le point de base est chargé par un potentiel (VZ), qui est plus proche du potentiel de référence (VB*), présent sur la seconde borne d'alimentation, que ne l'est le potentiel (VZ) présent au point de base de la cellule I²L effectuant la commande, caractérisé par le fait que l'injecteur (j) de la cellule I²L commandée est situé entre la base du transistor (t) et le point de base de cette cellule I²L).

2. Circuit à semiconducteurs suivant la revendication 1, caractérisé par le fait que le collecteur du transistor (T) de la cellule I²L effectuant la commande est relié directement à la base du transistor (t) de la cellule I²L commandée.

3. Circuit à semiconducteurs suivant la revendication 1, caractérisé par le fait que la commande de la base du transistor (t) de la cellule I²L commandée est effectuée par le collecteur du transistor (T) de la cellule I²L effectuant la commande, par l'intermédiaire d'au moins une diode.

4. Circuit à semiconducteurs suivant la revendication 3, caractérisé par le fait que le collecteur du transistor (T) de la cellule I²L effectuant la commande est relié directement à la base du transistor (t) d'une autre cellule I²L commandée, pour laquelle l'entrée de l'injecteur (j) est raccordée à l'entrée de l'injecteur (J) de la cellule I²L effectuant la commande et le point de base est raccordé au point de base de cette cellule.

5. Circuit à semiconducteurs suivant la revendication 1, caractérisé par le fait qu'à la cellule I²L commandée est associé un second injecteur (I) dont l'entrée est raccordée au collecteur du transistor (T) de la cellule I²L effectuant la commande et dont la sortie est raccordée à la base du transistor (t) de la cellule I²L commandée.

# FIG 1

# FIG 2

# FIG 3